# EUROPÄISCHE PATENTANMELDUNG

(11) **EP 2 523 347 A2**
(43) Veröffentlichungstag der Anmeldung: **14.11.2012**
(21) Anmeldenummer: 12002854.3
(22) Anmeldetag: 24.04.2012
(51) Int. Cl.: H03G 11/00, H03G 11/02

(54) **Begrenzerschaltung**

(30) Priorität: 13.05.2011 DE 102011101577
(71) Anmelder: EADS Deutschland GmbH, 85521 Ottobrunn (DE)
(72) Erfinder: Brokmeier, Axel, 89233 Neu-Ulm (DE)
(74) Vertreter: Riegel, Werner

(57) **Zusammenfassung**

Die Erfindung betrifft eine Begrenzerschaltung umfassend einen HF-Eingang (E) und einen HF-Ausgang (A), wobei zwischen dem HF-Eingang (E) und dem HF-Ausgang (A) eine NIP- Diode (1) und eine PIN-Diode (2) geschaltet sind, wobei der Kathodenanschluss (K1) der PIN-Diode (1) und der Anodenanschluss (A2) der NIP-Diode (2) mit Masse (M) verbunden sind und wobei der Anodenanschluss (A1) der PIN-Diode (1) und der Kathodenanschluss (K2) der NIP-Diode (2) miteinander verbunden sind und über jeweils eine Kapazität (C1, C2) mit dem HF-Eingang (E) und dem HF-Ausgang (A) verbunden sind.

## Beschreibung

Die Erfindung betrifft eine Begrenzerschaltung gemäß den Merkmalen des Patentanspruchs 1.

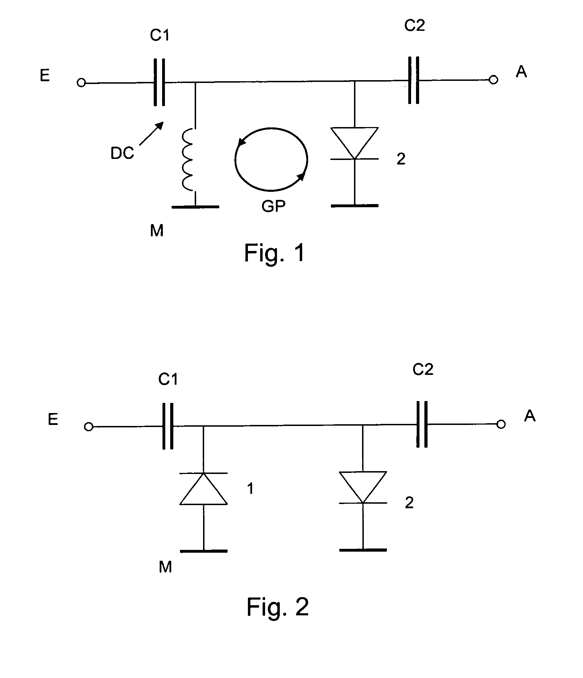

In Hochfrequenzschaltungen wird üblicherweise eine Komponente benötigt, welche die Amplitude eines Hochfrequenzsignals begrenzt. Eine Anwendung ist z.B. der Schutz des rauscharmen Vorverstärkers (LNA) am Eingang eines Empfängers. Fig. 1 zeigt das Ersatzschaltbild einer Begrenzerschaltung, wie er üblicherweise in Hochfrequenzschaltungen eingesetzt wird.

Üblicherweise besteht eine Begrenzerschaltung aus einer Limiterdiode 1 (PIN-Diode) und einem Schaltungselement, das den Gleichstromfluss im Sperrzustand des Limiters (d.h. die Diode ist leitend) gewährleistet. In dem in Fig.1 gezeigten Ersatzschaltbild ist es eine Induktivität I, auch DC-Return DC genannt. Der DC-Return soll den Leistungstransport des HF-Signals im nichtleitenden Zustand der Diode 2 nicht stören, aber den durch Gleichrichtung erzeugten Gleichstrom ungehindert leiten können. Der Gleichstrompfad (Bezugszeichen GP in Bild 1) wird von den anderen Teilen der HF-Schaltung durch Kapazitäten C1, C2 entkoppelt. Die Beschaltung der Limiterdiode 1 mit einem DC-Return (hier z.B. einer Induktivität) führt zu einer Reduzierung der HF-Bandbreite, sowie zu Signalverlusten.

Eine Begrenzerschaltung, welche mittels NIP- und PIN-Dioden aufgebaut ist, ist aus US 2006/0255879A1 bekannt. Eine weitere Begrenzerschaltung gemäß dem Oberbegriff des geltenden Anspruchs 1 ist aus US 2010/0277839 A1 bekannt.

Aufgabe der Erfindung ist es, eine gegenüber dem Stand der Technik breitbandigere Begrenzerschaltung mit geringen Signalverlusten anzugeben.

Diese Aufgabe löst die Begrenzerschaltung mit den Merkmalen des geltenden Patentanspruchs 1. Eine vorteilhafte Ausgestaltung der Erfindung ist Gegenstand von einem Unteranspruch.

Die Erfindung wird anhand von Figuren näher erläutert. Es zeigen:
- Fig. 1: eine Begrenzerschaltung gemäß dem Stand der Technik,
- Fig. 2: eine erfindungsgemäße Begrenzerschaltung,
- Fig. 3: eine erfindungsgemäße Begrenzerschaltung in einer vorteilhaften Ausführung.

Die erfindungsgemäße Begrenzerschaltung umfasst einen HF-Eingang E und einen HF-Ausgang A. Zwischen dem HF-Eingang E und dem HF-Ausgang A sind eine NIP-Diode 1 und eine PIN-Diode 2 geschaltet. Der Kathodenanschluss K2 der PIN-Diode 2 und der Anodenanschluss A1 der NIP-Diode 1 sind mit Masse M verbunden und der Anodenanschluss A2 der PIN-Diode 2 und der Kathodenanschluss K1 der NIP-Diode 1 sind miteinander und über jeweils eine Kapazität C1, C2 mit dem HF-Eingang E und dem HF-Ausgang A verbunden.

Bei der erfindungsgemäßen Begrenzerschaltung wird der DC-Return DC durch eine NIP-Diode 1 ersetzen und man erhält ein Ersatzschaltbild, wie in Bild 2 zu sehen. Die NIP-Diode 1 bildet also quasi den DC-Return DC für die PIN-Diode 2.

Der Vorteil dieser Schaltung besteht in einer deutlichen Erhöhung der Bandbreite. Die hohe Bandbreite wird erreicht, weil der Aufbau sehr kompakt ist und auf Leitungselemente, die den nutzbaren Frequenzbereich einschränken würden, verzichtet wurde.

Die Begrenzerschaltung kann einen Nutzfrequenzbereich von ca. 0,5GHz bis über 20GHz abdecken.

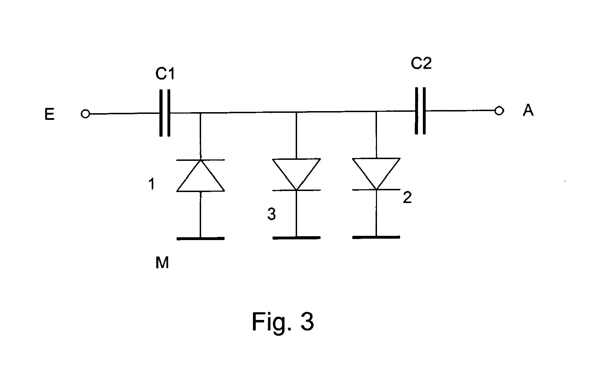

Eine zusätzliche weitere Eigenschaft eines derartigen Limiters besteht darin, dass durch Parallelschaltung einer weiteren Diode 3 (PIN oder NIP) die Leakage Power der Begrenzerschaltung auf einfache Weise reduziert werden kann. Die Leakage Power ist die Leistung, die im limiterenden Zustand der Begrenzerschaltung noch durchgelassen wird. Die dritte Diode 3 wird zweckmäßig parallel zu den anderen Dioden geschaltet (Fig. 3). Falls die dritte Diode eine PIN-Diode ist, stellt die NIP-Diode den Pfad für den Strom dar. Falls die dritte Diode eine NIP-Diode ist, stellt in diesem Fall die PIN-Diode den Strompfad dar. Die Bandbreite der Begrenzerschaltung bleibt nahezu erhalten.

Bei geeigneter Wahl der Dioden-Parameter wird die Leakage Power weiter verringert. Die Bandbreite wird nur unwesentlich verändert, da keine Leitungselemente zwischen den Dioden angeordnet sind.

## Patentansprüche

1. Begrenzerschaltung umfassend einen HF-Eingang (E) und einen HF-Ausgang wobei zwischen dem HF-Eingang (E) und dem HF-Ausgang (A) eine NIP- Diode (1) und eine PIN-Diode (2) geschaltet sind,
**dadurch gekennzeichnet, dass**
der Kathodenanschluss (K2) der PIN-Diode (2) und der Anodenanschluss (A1) der NIP-Diode (1) mit Masse (M) verbunden sind und
wobei der Anodenanschluss (A2) der PIN-Diode (2) und der Kathodenanschluss (K1) der NIP-Diode (1) miteinander verbunden sind und über jeweils eine Kapazität (C1, C2) mit dem HF-Eingang (E) und dem HF-Ausgang (A) verbunden sind.

2. Begrenzerschaltung nach Anspruch 1,
**dadurch gekennzeichnet, dass**
eine weitere PIN- oder NIP-Diode (3) vorhanden ist, welche zu der NIP-Diode (1) und der PIN-Diode (2) parallel geschaltet ist.
